# EUROPEAN PATENT SPECIFICATION

(11) **EP 0 252 634 B1**
(45) Date of publication and mention of the grant of the patent: **09.10.1996**
(21) Application number: 87305442.3
(22) Date of filing: 19.06.1987
(51) Int. Cl.: G01R 33/20, H01F 7/20

(54) **Magnetic field coils**
Spulen zur Erzeugung von Magnetfeldern
Bobines de production d'un champ magnétique

(30) Priority: 28.06.1986 GB 8615854
(43) Date of publication of application: 13.01.1988
(73) Proprietor: BRITISH TECHNOLOGY GROUP LIMITED, London SE1 6BU (GB)
(72) Inventor: Turner, Robert, Bramcote Nottingham NG9 3JY (GB); Mansfield, Peter, Beeston Nottingham (GB); Chapman, Barry Leonard Walter, Beeston Nottingham (GB)
(74) Representative: Davis, Norman Norbridge

(56) References cited:
- EP-A- 0 086 560
- EP-A- 0 136 536
- EP-A- 0 138 270
- EP-A- 0 140 259
- EP-A- 0 210 289
- EP-A- 0 216 590
- EP-A- 0 231 879
- WO-A-86/04687
- US-A- 3 515 979
- US-A- 3 582 779
- US-A- 4 506 247
- G. Arfken, MATHEMATICAL METHODS FOR PHYSICISTS, Academic Press, New York, 1970, second edition, pages 733-734 and 748-749
- Magn.Res.Med., vol. 1, 1984, p. 44-65

## Description

The present invention relates to magnetic field coils and more particularly to coils designed to produce a defined field in at least one volume.

In many applications it is important to provide a magnetic field the characteristics of which, for example, in an x-y plane is known. For example, in virtually every application of NMR spectroscopy and imaging it is essential to use magnetic fields whose spatial variation is controlled. Such fields may be uniform, or they may have a linear variation in either x, y or z (where x, y, z are the co-ordinate axes), or they may be uniform within a certain volume and rapidly changing elsewhere, as in TMR. For fine-tuning correction of nearly uniform main fields it is useful to have a set of shim coils, which provide known correction gradients, varying as xy, x² - y², yz etc.

It is an object of the present invention to provide coils which are designed in a manner suitable for generating any of the fields mentioned.

The coils are formed by conductors, which lie on a surface, and the positions of the conductors are derived directly from the specification of the field desired at a further target surface which may be smaller or larger than the former surface. Coils designed according to the principle to be described can provide very large volumes within which the field follows a specified variation, and are thus exceptionally efficient and compact.

European Patent No. 086560 discloses a method of calculating the surface current density for a coil using a least squares approximation to provide a compromise solution for the required continuous current density.

EP-A-0140259 (Edelstein) discloses a method of calculation of surface current distribution in a cylinder required to produce a gradient field. The method performs calculations in real space and uses harmonic expansion of the magnetic field up to a finite order in the expansion.

US-A-3,515,979 (Golay) discloses a method of designing shim coils to correct magnetic field inhomogeneities by empirically adding in harmonic components from orthogonal shim coils designed according to the Golay principle.

WO-A-86/04687 (Halbach) Article 54(3) and 158(1), (2) EPC discloses a gradient coil construction which forms linear gradients by imposing a sinusoidal variation in the azimuthal direction, uniformly in the axial and with return paths coincident at some arbitrary axial distance. The magnet includes a plurality of current-carrying conductors disposed such that the current density in the azimuthal direction is proportional to the sine of the angle φ. The conductor positions are determined from the continuous surface current density such that each conductor carries equal integrated current density. The conductors are further disposed such that the current density in the direction parallel to the magnet axis is proportional to the distance from the central or Z=0 plane in the direction of the magnet axis multiplied by the cosine of the azimuthal angle φ.

EP-A-0216590 (Mansfield) Article 54(3) EPC discloses a method of providing currents required in a shield or shields which results in cancellation of a total gradient field at a specific radius.

EP-A-0231879 (Roemer) Article 54(3) EPC discloses a solution to the problem of providing a good quality gradient field by a successive approximation technique by adjusting a limited set of design parameters until a least squares fit to a field specified at a finite set of discrete points is obtained. The first step in finding a desired winding pattern is to write the pre-defined surface current for an inner coil in terms of a stream function and to use Fourier decomposition of the inner coil stream function and then by analysis of the magnetic fields produced by the inner and outer coil to produce an expression for a total coil stream function which is chosen to give a zero magnetic field in a definite region.

EP-A-231879 also disclosed Fourier decomposition of an inner coil stream function and analysis of the magnetic fields produced by inner and outer coils to provide an expression for an outer coil stream function which is chosen to give a zero magnetic field in a defined region.

EP-A-0210289 (Keim) Article 54(3) discloses a coil design method of cancellation of unwanted cylindrical harmonic field inhomogeneities term by term.

EP-A-0136536 (Schenck) discloses a cylindrical coil for providing a magnetic field having a substantially linear gradient in the axial direction and uses a combination of spherical harmonics and the cylindrical co-ordinate system to analyse the problem of generating uniform longitudinal magnetic field gradients. The approach adopted is to eliminate variations in the linearity of the magnetic field along the axis of higher order, Z³ and above, by placement of additional windings at one specific position. The conductor positions are determined by a calculation of the continuous current density on a surface and by positioning along streamlines of the current distribution.

G. Arfken, Mathematical Methods for Physicists, 1970, New York, US, pages 733-734 and 748-749 disclose a mathematical method for inverting second order differential equations. They show how the Poisson equation of electrostatics can be analysed by Green's function methods (EQ.16.116). In example 16.2 they show how a convolution integral equation can be factorised in reciprocal space.

According to the present invention, there is provided a method of producing a coil as claimed in claim 1

In one class of preferred surfaces, the surface or surfaces are cylinders and the target surface or surfaces are also cylinders.

The cylinder on which the conductors are positioned may, for example, be a cylinder of a non-ferromagnetic material such as glass reinforced plastic, or the cylinder may be notional, the coils being merely shaped to conform to a cylindrical or partially cylindrical shape.

In a first preferred embodiment, the cylinder on which the coil conductors are to be mounted is of larger diameter than the diameter of the target cylinder, the coil therefore being designed to produce a known field within the cylinder.

In a second preferred embodiment the target cylinder is of larger diameter than the cylinder. This is particularly useful where a specified field is required outside a coil.

In a further embodiment the coil design may be obtained from calculations carried out on first and second target cylinders, the first being of smaller diameter and the second of larger diameter. The coil designed by this method can therefore produce defined magnetic fields both within the first cylinder and outside the second cylinder.

In a further embodiment a plurality of coaxial cylindrical or semi-cylindrical coils can be designed to produce various fields specified on target cylinders in all but one of the intervening spaces, and within the centre cylinder.

In a preferred embodiment the field within the inner cylinder is uniform and outside the outermost cylinder the field is zero. Alternatively, the inner field may be zero within a defined outer field.

Embodiments of the present invention will now be described, by way of example with reference to the accompanying drawings in which:-
Figure 1 shows a cylinder or notional cylinder used to explain the principle of the present invention;
Figure 2 shows an end view of a squirrel cage r.f. coil with six turns;
Figure 3a, b, c and d show the design of a saddle coil for production of an x gradient (one octant only of the coil being shown) and uniformity maps for d = 1.5a and return path at d = 2.0a;
Figure 4 shows a design of saddle coil (one octant only) for x gradient to be driven in parallel, the return paths not being shown;
Figure 5 shows the variation of target magnetic field (Bz) with z for an end corrected saddle coil;
Figure 6 shows a design of end corrected saddle coil (one octant only);
Figure 7 shows a design of longitudinal gradient coil with 12 arcs; and
Figure 8 shows the current density required to produce a uniform magnetic field.

The calculation of current density required to generate given field according to the present invention is given as follows:-

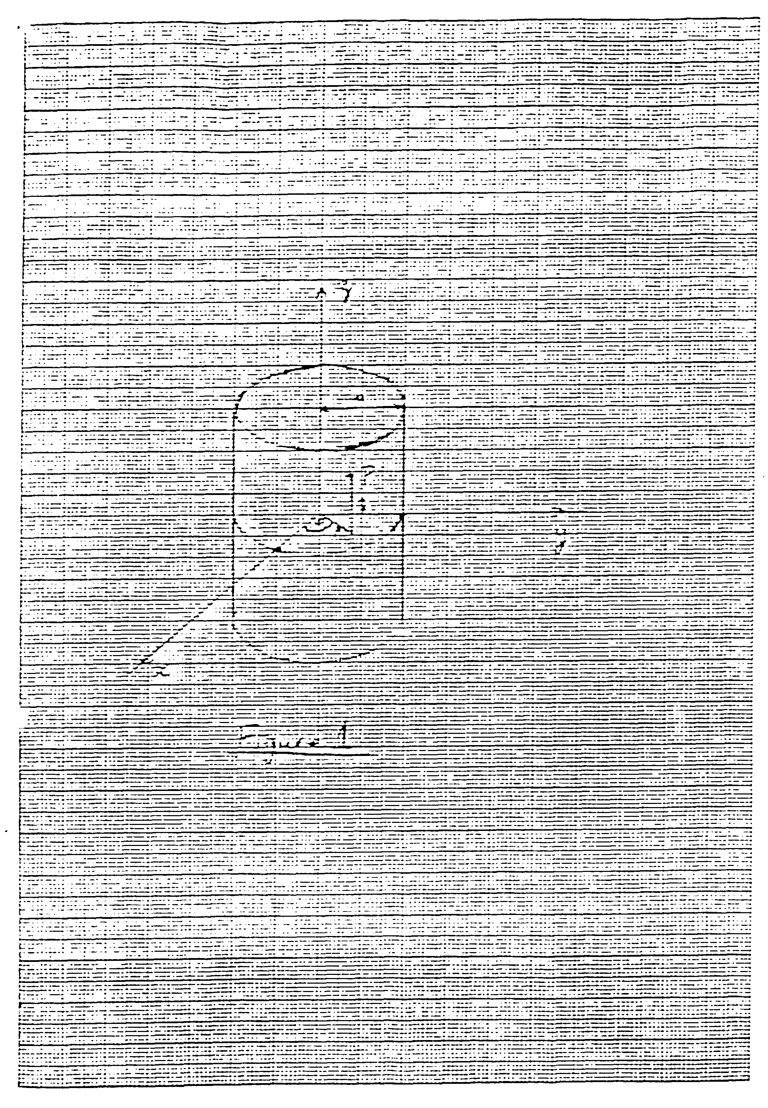

The crucial observation leading to improved coil designs is that the z component of the magnetic field produced by the current density F (φ, z) flowing on a cylinder of radius a (Figure 1) is given by (see Patent Application 128688). 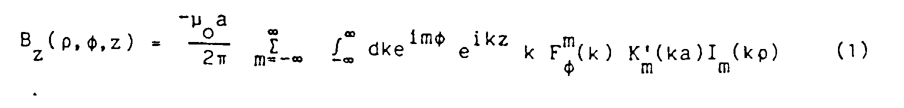 where

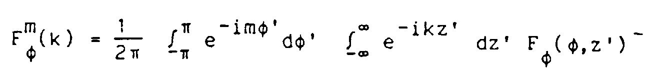

Here Bz is defined as the magnetic field in the axial direction, Kₘ(x) and Iₘ(x) are the modified Bessel functions, and the surface current F has components F_{φ} and F_{Z} in the azimuthal and axial directions respectively.

Now suppose we are given B_{Z} (c, φ, z) for a particular value of c < a that is to say, we are given the field on the further cylinder of radius c. We may invert equation (1) by integrating each side with respect to φ and z: 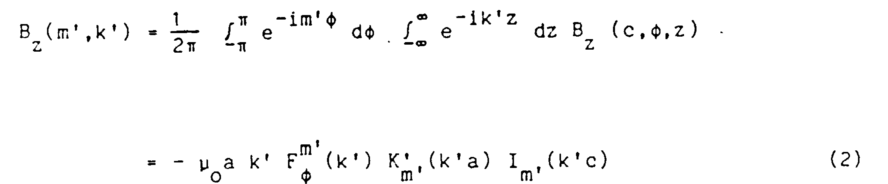 Thus the Fourier transform of the magnetic field B₂ has been factorised in equation 2 into the product of the Fourier transfrom of the current density and standard Bessel functions. Thus we may write${\text{F}}_{\text{φ}}^{\text{m}} \left(\text{k}\right) \text{=-} \frac{\text{1}}{{\text{µ}}_{\text{o}} \text{a}} \frac{{\text{B}}_{\text{z}} \left(\text{m,k}\right)}{{\text{k K}}_{\text{m}}^{\text{'}} \left(\text{ka}\right) {\text{I}}_{\text{m}} \left(\text{kc}\right)}$ The current density F_{φ} (φ, z) may then be obtained:

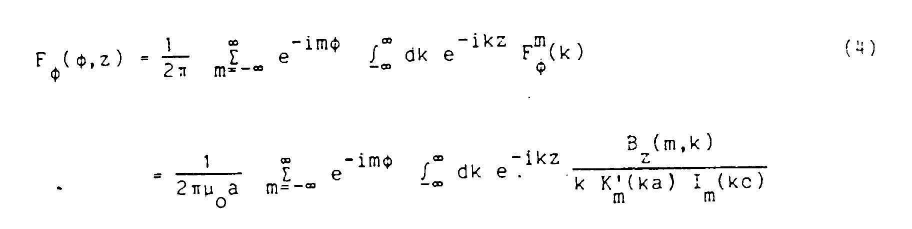

Hence, given B_{z}(c, φ, z) we may obtain the required current F_{φ} (φ, z). Note that the other component of the current in the cylinder, F_{Z} (φ, z) can be obtained using the equation of continuity, which gives$\frac{{\text{∂F}}_{\text{z}}}{\text{∂z}} \text{=-} \frac{\text{1}}{\text{a}} \frac{{\text{∂F}}_{\text{φ}}}{\text{∂φ}}$ or in terms of m and k:${\text{KF}}_{\text{z}}^{\text{m}} \left(\text{k}\right) \text{=-} \frac{\text{m}}{\text{a}} {\text{F}}_{\text{φ}}^{\text{m}} \left(\text{k}\right)$ Equation (4) has a certain peculiarity, For large k the denominator kK$\frac{\text{'}}{\text{m}}$(ka)Iₘ(Kc) tends to e^{-k(a-c)}. Hence the integral in equation (4) will fail to converge unless |B_{Z} (m,k)| decreases faster than e^{-k(a-c)} as k→∞. In particular this rules out the possibility of creating a field which has the form${\text{B}}_{\text{Z}} {\text{= B}}_{\text{O}} \text{|z| < d = O elsewhere,}$ since this gives a B_{Z} (m, k) which decreases only as 1/k.

A useful class of functions to describe the variation of B_{Z}(c, φ, z) is the set$\text{g} \left(\text{z}\right) \text{=} \frac{{\text{z}}^{\text{s}}}{\text{1+(} \frac{\text{z}}{\text{d}} {\text{)}}^{\text{n}}}$ where s and n (n even) are integers. For z < d/2 this diverges from z^{s} only by order of (z/d)ⁿ, and the Fourier transform of g(z) is well known. For large k this decreases as$\text{e} {\text{}}^{\text{-kd sin} \frac{\text{π}}{\text{n}}} \text{,}$ requiring that the characteristic length d of the coil must be such that$\text{dsin π/n > a.}$

For many imaging purposes it is sufficient to take n = 6; this gives correction up to sixth order in the z direction. For instance, if a transverse gradient is to be uniform in the z direction, we take s = O. Then at z = ±d/2 the magnitude of the gradient has dropped by only 1/64, i.e. 1.5%. Correction to higher order may be achieved by making n larger, but this increases the length of the coil.

The variation B_{Z} (c, φ, z) may also be specified point by point over the entire target surface and the Fourier transform B(m,k) computed numerically. It is still necessary to ensure that B(m,k) decrease with k sufficiently fast for the integral in (4) to converge.

Note that most fields of interest have either cylindrical symmetry (m = O in equation (1)) or reflection symmetry about the xz or yz plane (m = ± 1 in equation (1)). Thus we are normally dealing with${\text{F}}_{\text{φ}}^{\text{c}} \left(\text{k}\right) \text{=-} \frac{\text{1}}{{\text{µ}}_{\text{O}} \text{a}} \frac{{\text{B}}_{\text{Z}} \left(\text{0, k}\right)}{{\text{k K}}_{\text{O}}^{\text{'}} \left(\text{ka}\right) {\text{I}}_{\text{O}} \left(\text{kc}\right)}$ or${\text{F}}_{\text{φ}}^{\text{1}} \left(\text{k}\right) \text{=-} \frac{\text{1}}{{\text{µ}}_{\text{O}} \text{a}} \frac{{\text{B}}_{\text{z}} \left(\text{1, k}\right)}{{\text{k K}}_{\text{1}}^{\text{'}} \left(\text{ka}\right) {\text{I}}_{\text{1}} \left(\text{kc}\right)}$

Once the continuous current distribution required to generate the specified field has been found, it is necessary to find practical means for approximating such a distribution as closely as possible. In one preferred embodiment these currents are confined to wire arcs. There are two ways of arranging such arcs; (a) equal current in each arc, i.e. series activated, and (b) equal voltage drop down each arc, i.e. parallel activated. It is considerably simpler to calculate the arc positions required in case (a), though case (b) can also be dealt with in an entirely satisfactory way, using an iterative method.

### Arc Position Algorithm

The basic principle for finding n arc positions for series activation, given the surface current density, is to subdivide the surface of the cylinder into 2n areas, in each of which flows an equal integrated surface current. These areas are of course separated by contours of equal current density. The arc positions are then taken at the odd-numbered contours. In this way each arc carries the current for a surface area on each side of it, closely approximating the effect of a continuous current density. The approximation is valid for magnetic fields calculated at radii less than the cylinder radius minus half the arc separation at that position.

In practice this means calculating the stream function Iₜ of the current density 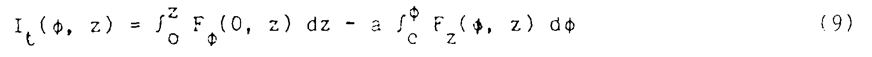 and finding the maximum value of Iₜ(φ,z) = Iₒ, dividing Iₒ by 2n where n = number of arcs, and setting$\frac{{\text{I}}_{\text{O}}}{\text{2n}} \left(\text{2m - 1}\right) {\text{=I}}_{\text{t}} \left(\text{φ, z}\right)$ to determine the arc positions.

In certain cases the arc positions may be obtained more easily by integrating the relationship$\frac{\text{dz}}{{\text{F}}_{\text{z}} \left(\text{φ, z}\right)} \text{=+} \frac{\text{a dφ}}{{\text{F}}_{\text{φ}} \left(\text{φ, z}\right)}$ which is the differential equation specifying the contours of F directly. This gives, in general${\text{F}}_{\text{Z}} {\text{(φ,z)F}}_{\text{φ}} {\text{(φ,z) = F}}_{\text{φ}} {\text{(φ}}_{\text{o}} {\text{,z)F}}_{\text{Z}} {\text{(φ,z}}_{\text{o}} \text{)}$ where zₒ and φₒ are constants.

### Specific Cases

It is advantageous to consider first the following examples which do not require the full target field approach.

### (a) RF coil

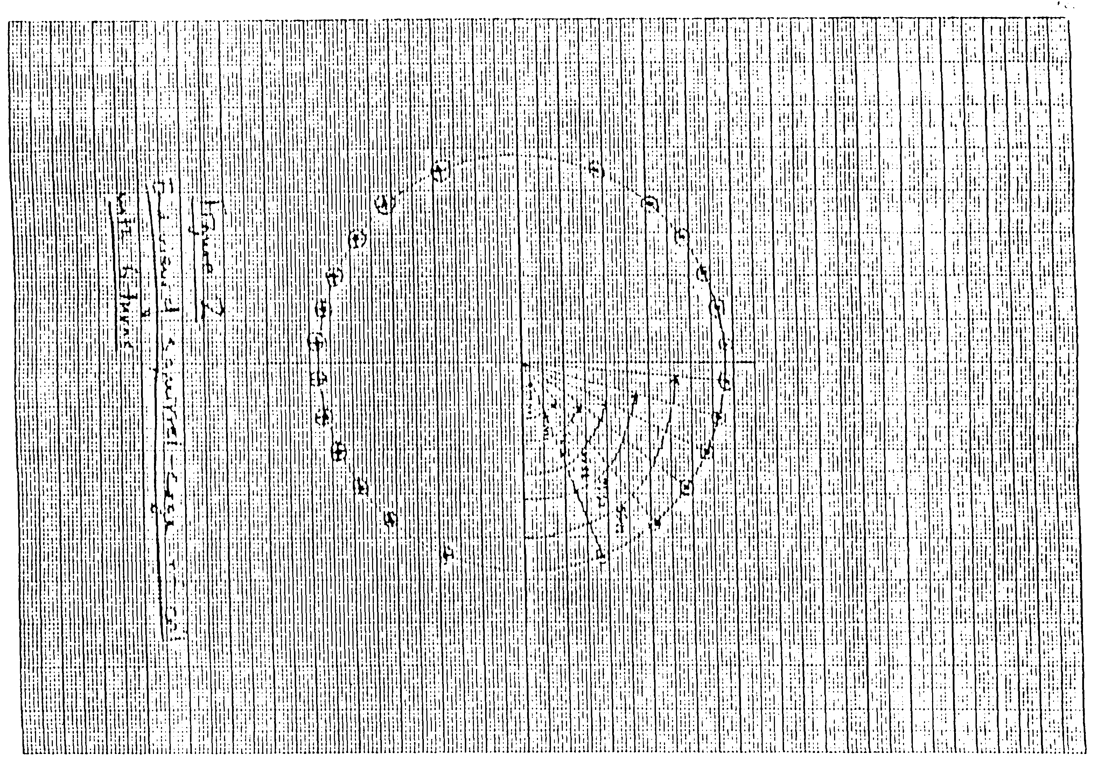

Here it is well known that a continuous current density F_{z} = $\frac{{\text{I}}_{\text{o}}}{\text{a}}$sin φ will give a uniform magnetic field in the x direction. An exceptionally good rf coil (Figure 2) can be designed using filamentary currents placed according to the prescription of equation (9). The required current return paths are circular arcs, which can be placed at z = ±d, sufficiently far from the region of interest for imaging that their effect can be neglected for |z| < d/2. For the straight section (9) gives 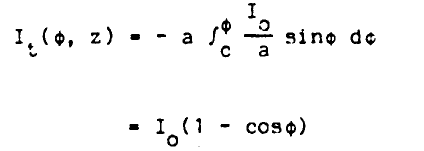 (10) then gives$\frac{{\text{I}}_{\text{o}}}{\text{2n}} {\text{(2m-1) = I}}_{\text{o}} {\text{(1-cosφ}}_{\text{m}} \text{)}$ so${\text{φ}}_{\text{m}} {\text{=cos}}^{\text{-1}} \text{(1-} \frac{\text{m-1/2}}{\text{n}} \text{)}$ Straight line sections placed at these positions, corresponding to equal spacing in the x direction, give a remarkably uniform B x over a large volume. Generally, if the return path distance d > 2a, the field is uniform to 4% over a cylinder of length d and radius b, where$\text{b=a(1-} \frac{\text{1}}{\text{2}} {\text{cos}}^{\text{-1}} \text{(1-} \frac{\text{1}}{\text{2n}} \text{))}$ For n = 6, b = 0.8a.

By comparison, a typical saddle-type rf coil of similar dimensions, corresponding to n = 1 in equation (12), has a volume of similar uniformity of length 0.7d and radius 0.45a. The efficiency of the squirrel cage design, measured as the ratio of Bₓ to the amperes-turns of wire used, is smaller by a few per cent than a saddle coil of similar dimensions, though the efficiency of a saddle coil giving an equivalent volume of uniformity is less by a factor of two. Orthogonal arrangement of receiver and transmitter rf coils is achieved easily by rotating the coil design by π/2 about the z axis. The squirrel cage design may also be driven in a parallel arrangement, providing a very low effective inductance, and this is useful at high rf frequencies.

### (b) Transverse gradient coil: no end-correction

An ideal transverse gradient, where${\text{B}}_{\text{z}} \text{= x G = ρ G cosφ}$ (where G is the gradient $\frac{{\text{∂B}}_{\text{z}}}{\text{∂x}}$).
can be achieved using a current density which has m = ± 1 and no variation with z only (cf. equation (8)). Here${\text{B}}_{\text{z}} \text{(±1, k)=} \frac{\text{Gc}}{\text{4}} \text{δ(k)}$ and${\text{F}}_{\text{φ}} \text{(φ, z)=} \frac{\text{π}}{{\text{2µ}}_{\text{o}}} \text{a Gcosφ}$ Equation (5a) requires that$\frac{{\text{∂F}}_{\text{z}}}{\text{∂z}} \text{=} \frac{\text{π}}{{\text{2µ}}_{\text{o}}} \text{G sinφ}$${\text{F}}_{\text{z}} \text{=} \frac{\text{zπ}}{{\text{2µ}}_{\text{o}}} \text{G sinφ}$ The arc positions may be found using equation (11):$\frac{\text{dz}}{\frac{\text{zπ}}{{\text{2µ}}_{\text{o}}} \text{G sinφ}} \text{=} \frac{\text{adφ}}{\frac{\text{π}}{{\text{2µ}}_{\text{o}}} \text{a G cosφ}}$ Taking the length of the coil to be d,$\frac{\text{d}}{\text{z}} \text{=} \frac{\text{cosφ}}{\text{α}}$ where α = constant, defining a contour.
If n arcs are required, the position of the m'th arc is given by$\text{cosφ=} \frac{\text{d}}{\text{z}} \text{·} \frac{\text{2m-1}}{\text{2n}}$

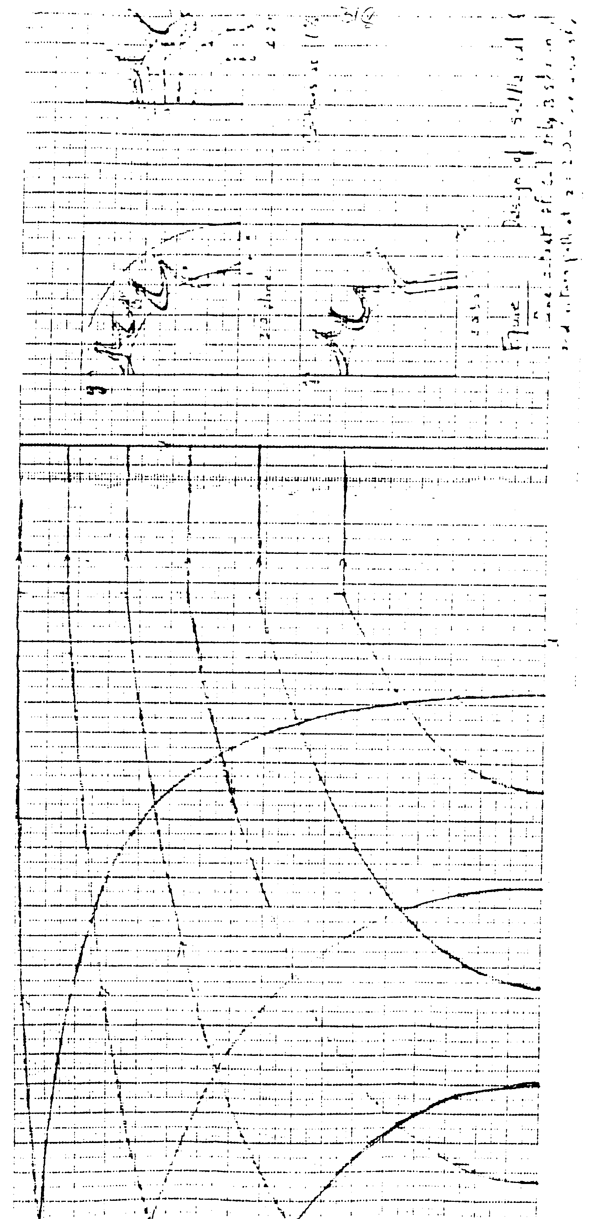

Normally, to avoid undesirable transverse fields, a pair of such coils would be combined to provide symmetry about the z = O plane, as shown in Figure 3. Here the two coils are overlapped to minimise the separation between adjacent wire segments, and hence to maximise the radius of gradient uniformity. The current return paths are taken simply as circular arcs at z = 1.25d. Typically, for six-arc coils, with d/a = 2, the volume over which the gradient is uniform to within 5% is a cylinder of radius 0.8a and length 2a. Increasing the number of arcs will increase the total inductance, if they are driven in series, but will also increase the radius of the uniform gradient region.

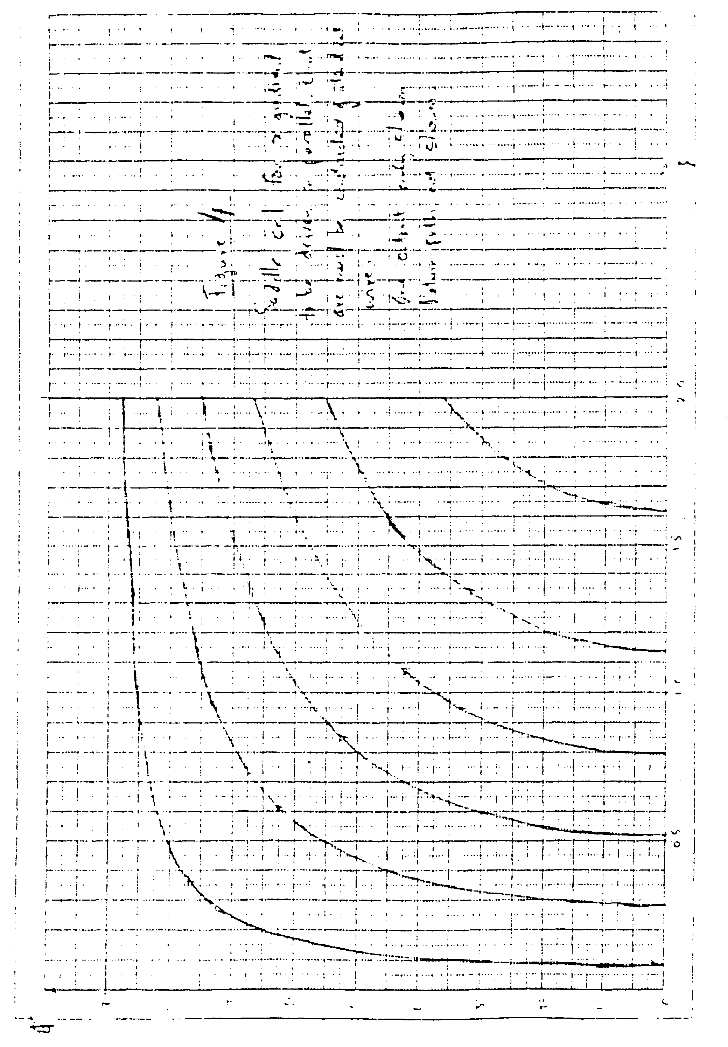

The wires may alternatively be moved into positions where they can be driven in parallel, the current being then determined by the relative length of the arc. This is an efficient arrangement for maximising the volume of uniform gradient. An iterative program has been written to achieve this, a typical coil design being shown in Figure 4.

### (c) Transverse gradient coil: with end corrections

For this coil design it is necessary to specify the desired field B_{Z} more carefully to include explicitly the effect of the current return paths. A combination of the functions g(z) described in equation (6a) is useful:${\text{B}}_{\text{z}} \text{(c,φ,z)=(} \frac{{\text{d}}_{\text{2}}}{\text{1+(} \frac{\text{z}}{{\text{d}}_{\text{1}}} {\text{)}}^{\text{6}}} \text{-} \frac{{\text{d}}_{\text{1}}}{\text{1+(} \frac{\text{z}}{{\text{d}}_{\text{2}}} {\text{)}}^{\text{6}}} \text{)} \frac{\text{G c cosφ}}{{\text{(d}}_{\text{2}} {\text{-d}}_{\text{1}} \text{)}}$

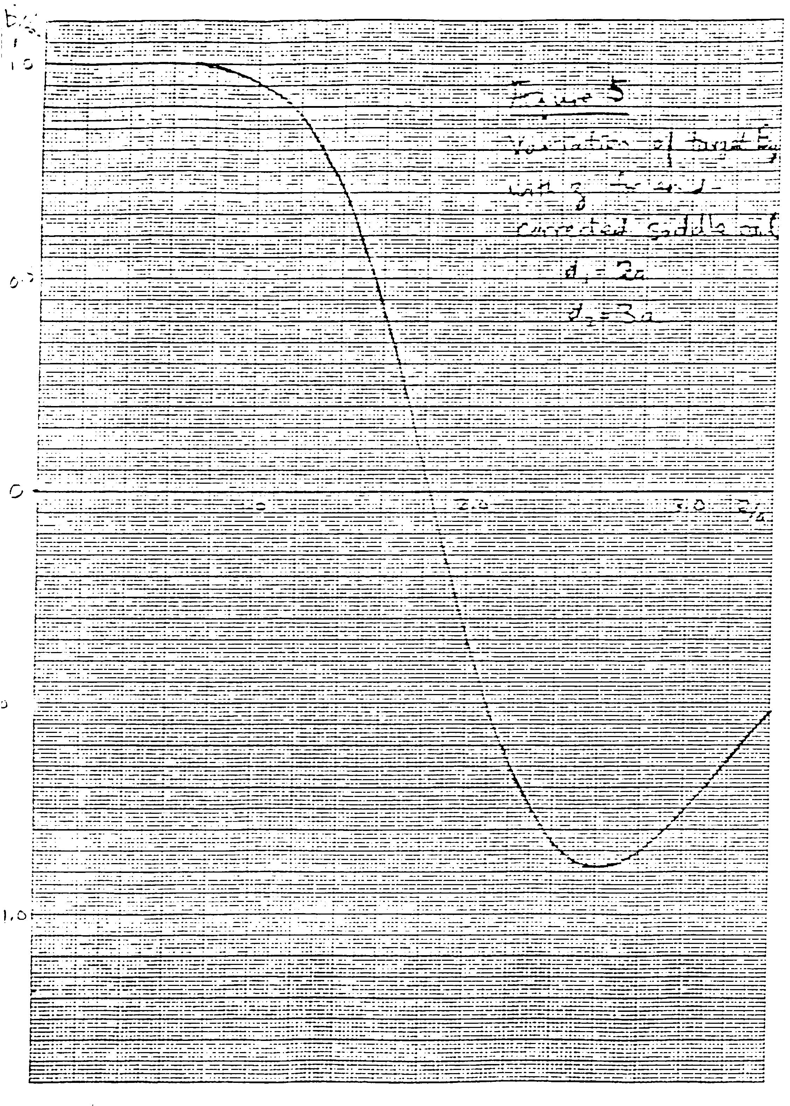

This gives a variation with z shown in Figure 5. For |z| < d₁/2 the uniformity is excellent along the z axis.

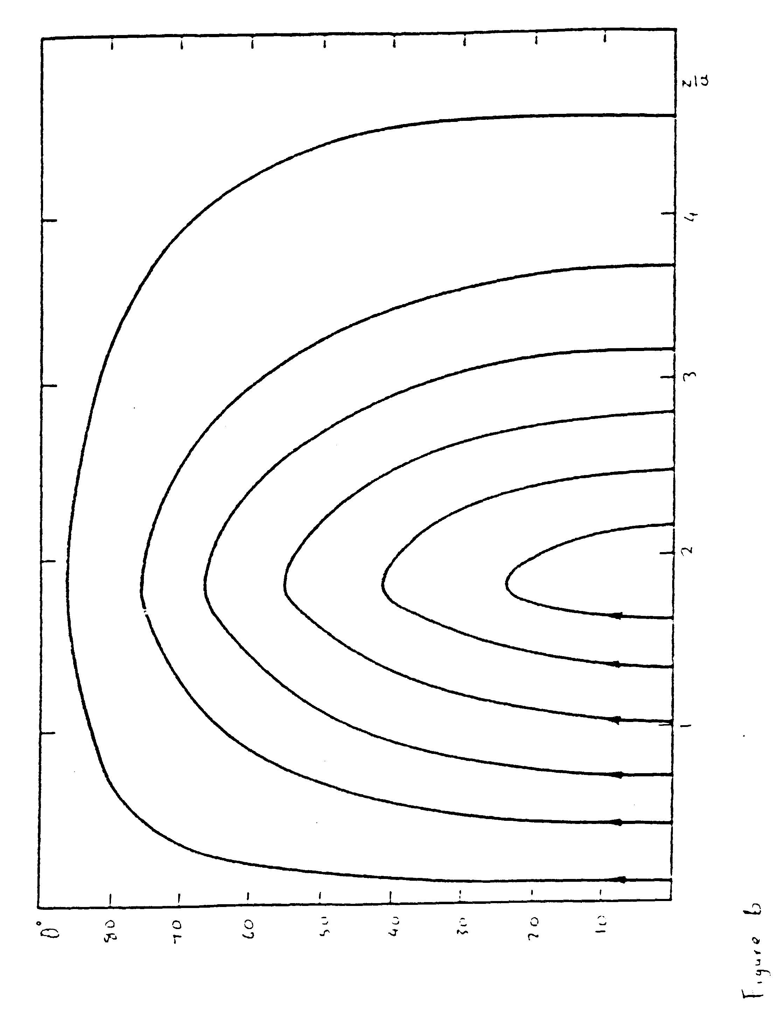

Use of equation (2) then gives, for m = ± 1${\text{B}}_{\text{z}} \left(\text{m,k}\right) \text{=} \frac{\text{G}}{\text{6}} \frac{{\text{d}}_{\text{1}} {\text{d}}_{\text{2}}}{{\text{d}}_{\text{2}} {\text{-d}}_{\text{1}}} \text{c [2e} {\text{}}^{{\text{-d}}_{\text{1}} \text{k/2}} {\text{sin(π/6 + d}}_{\text{1}} \text{k} \frac{\text{√3}}{\text{2}} \text{)} \text{-2e} {\text{}}^{{\text{-d}}_{\text{2}} \text{k/2}} {\text{sin (π/6 + d}}_{\text{2}} \text{k} \frac{\text{√3}}{\text{2}} \text{) + e} {\text{}}^{{\text{-d}}_{\text{1}} \text{k}} \text{-e} {\text{}}^{{\text{-d}}_{\text{2}} \text{k}} \text{]}$ and hence${\text{F}}_{\text{φ}}^{\text{±1}} \left(\text{k}\right) \text{=} \frac{{\text{-Gd}}_{\text{1}} {\text{d}}_{\text{2}} \text{c}}{{\text{6µ}}_{\text{o}} {\text{a(d}}_{\text{2}} {\text{-d}}_{\text{1}} \text{)}} \frac{\text{1}}{{\text{k K}}_{\text{1}}^{\text{'}} \left(\text{ka}\right) {\text{I}}_{\text{1}} \left(\text{kc}\right)} \text{x [2e} {\text{}}^{{\text{-d}}_{\text{1}} \text{k/2}} \text{sin(} \frac{\text{π}}{\text{6}} {\text{+d}}_{\text{1}} \text{k} \frac{\text{√3}}{\text{2}} \text{) - 2e} {\text{}}^{{\text{-d}}_{\text{2}} \text{k/2}} \text{sin(} \frac{\text{π}}{\text{6}} {\text{+ d}}_{\text{2}} \text{k} \frac{\text{√3}}{\text{2}} \text{) + e} {\text{}}^{{\text{-d}}_{\text{1}} \text{k}} \text{- e} {\text{}}^{{\text{-d}}_{\text{2}} \text{k}} \text{]}$ The integral in equation (4) converges for${\text{d}}_{\text{1}} \text{≧} \frac{\text{a}}{\text{sin π/6}}$ i.e.${\text{d}}_{\text{1}} \text{≧ 2a}$ Note that${\text{F}}_{\text{z}}^{\text{±}} \left(\text{k}\right) \text{= ∓} \frac{\text{1}}{\text{ak}} {\text{F}}_{\text{φ}}^{\text{±}} \left(\text{k}\right)$ The arcs may be found as before, by setting$\frac{\text{2m-1}}{\text{2n}} {\text{I}}_{\text{o}} {\text{=I}}_{\text{t}} \left(\text{φ, z}\right)$ with the results shown, for n = 6, in Figure 6. Since for z = O and φ = π/2 the wires are relatively widely spaced, it is preferable to have a larger number of turns n with this design. Given d₁ = 2a, d₂ = 3a and n ≥ 10, the coil gives a gradient which is uniform to 2% within a cylinder of radius 0.8a and length 2a.

### (d) Longitudinal gradient coil

This coil is a distributed-arc version of the well known Maxwell pair arrangement. The target field B_{z} is taken as${\text{B}}_{\text{z}} \left(\text{c, φ, z}\right) {\text{= B}}_{\text{z}} \left(\text{c, 0, z}\right) \text{=} \frac{\text{Gz}}{\text{1+(} \frac{\text{z}}{\text{d}} {\text{)}}^{\text{6}}}$ where G is the gradient $\frac{\text{∂Bz}}{\text{∂z}}$
Then${\text{B}}_{\text{z}} \left(\text{0, k}\right) \text{=} \frac{{\text{G πd}}^{\text{2}}}{\text{3}} {\text{(2e}}^{\text{-dk/2}} \text{cos(} \frac{\text{π}}{\text{3}} \text{+ dk} \frac{\text{√3}}{\text{2}} {\text{) - e}}^{\text{-dk}} \text{)}$ and

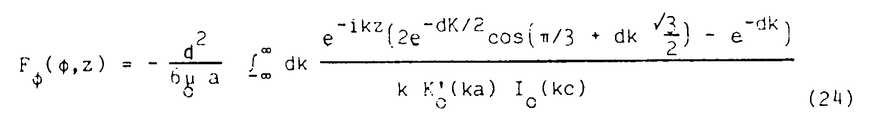

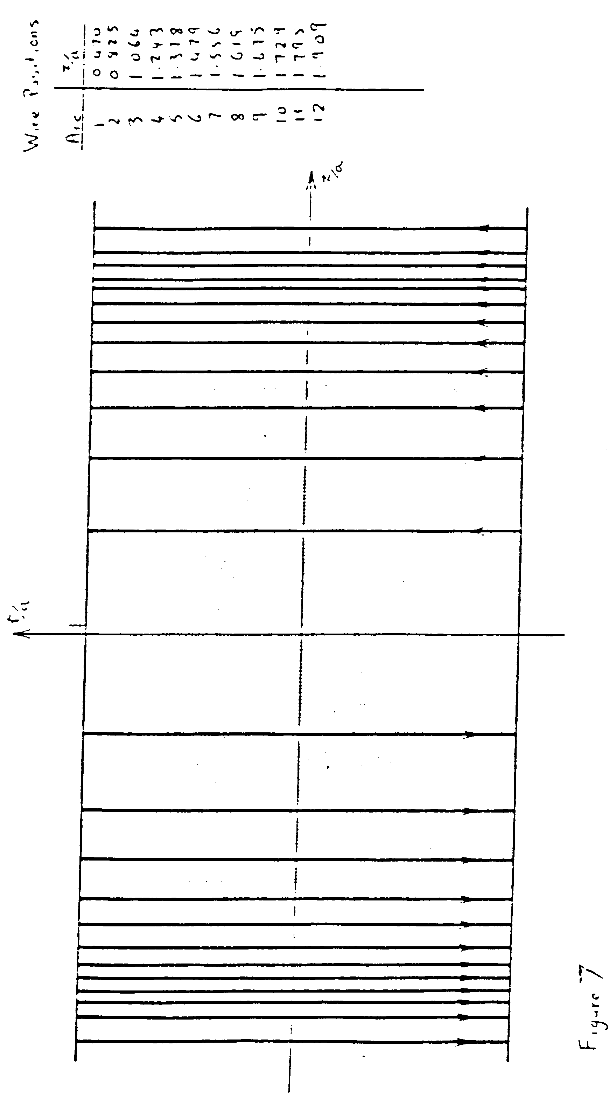

The shortest coil achievable, using the given functional form of target field, has a length 2a√3, which is double that of a conventional Maxwell pair, but a twelve turn version of this coil (Figure 7) gives a linear z gradient which is uniform to 5% within a cylinder of radius 0.7a and length 2.0a, a volume six times larger than a comparable Maxwell pair.

### (e) Uniform field coil

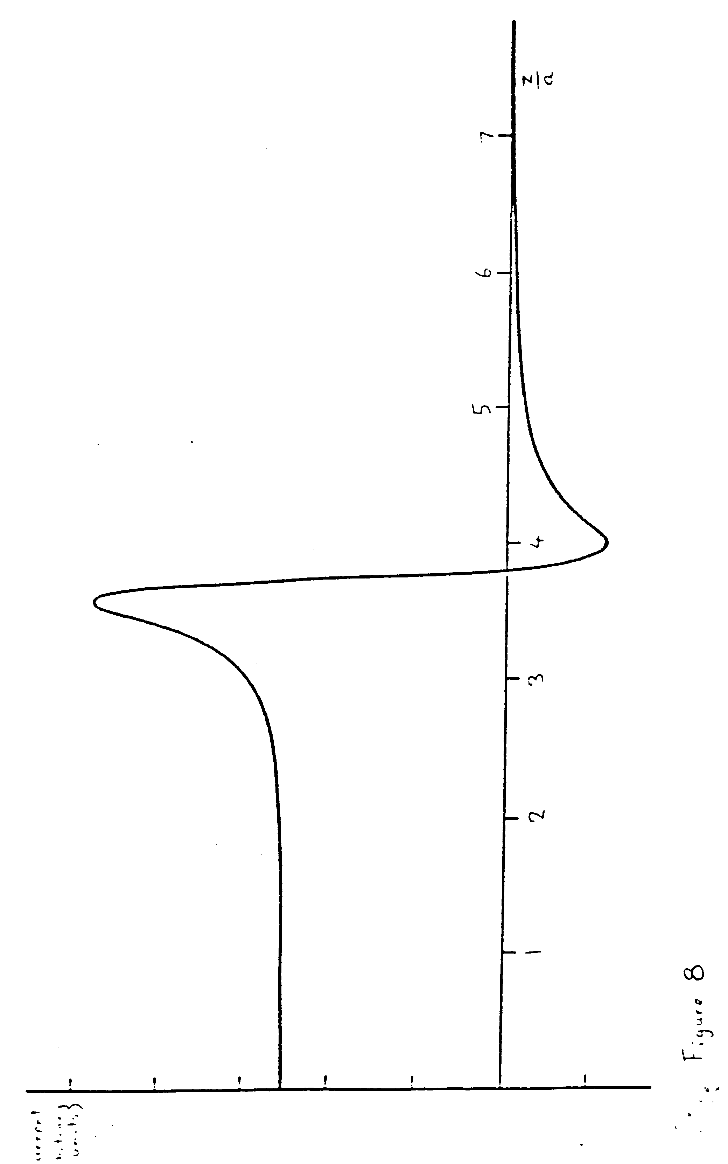

The algorithm described lends itself simply to the generation of highly uniform main magnetic fields. In order to provide correction to order (z/d)¹² it is necessary to have a coil length d = a/sinπ/12 = 3.86a. In return for this somewhat long configuration it is possible to achieve a magnetic field which is uniform to 0.2 ppm over 100% of the coil diameter and out to z = ±a. The current density required (Figure 8) can be provided using a large number of turns of wire, since for this application a high inductance causes no problems. Here${\text{B}}_{\text{z}} \text{(c, φ, z) =} \frac{{\text{B}}_{\text{o}}}{\text{1 + (} \frac{\text{z}}{\text{d}} {\text{)}}^{\text{12}}}$ and thus 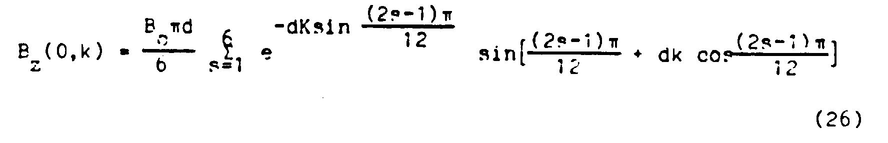 F(φ,z) = F(o,z) is found using equations (3) and (4). (f) Shim coils

The normal complement of shim coils provided for modern high quality magnets for spectroscopy or imaging consists of the following:
- (i) x: gradient
- (ii) y: gradient
- (iii) z: gradient
- (iv) xy: gradient
- (v) xz: gradient
- (vi ) yz: gradient
- (vii) z²: gradient
- (viii) z³: gradient
- (ix) z⁴: gradient
- (x) x²-y²: gradient

Coils specified as in sections (b), (c) and (d) can supply the first order gradients over a large usable volume. In order to provide the remaining gradients using distributed windings, the desired magnetic fields may be specified as follows, with the appropriate azimuthal coefficent numbers m listed:
- xy: B_{z}(c,φ,z) α c² sin2φg(z)
m = ±2
- xz: B_{z}(c,φ,z) α c cosφ h(z)
m = ±1
- yz: B_{z} (c,φ,z) α c sinφ h(z)
m = ±1
- z²: B_{z}(c,φ,z) α z² g(z)
m = 0
- z³: B_{z}(c,φ,z) α z³ g(z)
m = 0
- z⁴: B_{z}(c,φ,z) α z⁴ g(z)
m = 0
- x²-y²: B_{z}(c,φ,z) α c² cos2φ g(z) m = ±2
where$\text{g(z) =} \frac{\text{1}}{\text{1+(} \frac{\text{z}}{\text{d}} {\text{)}}^{\text{6}}}$ and$\text{h} \left(\text{z}\right) \text{=} \frac{\text{z}}{\text{1+(} \frac{\text{z}}{\text{d}} {\text{)}}^{\text{6}}}$

The current densities required to generate these fields, and thus the arc positions approximating them, can be derived as shown previously. In general these designs can be realised using many turns of wire, since shim coils are normally not switched, and therefore may be of high inductance. The volume over which these coils give the specified field to within 1.5% is then normally a cylinder of length 2a and radius a.

When specific fields are required in more than one region, the above principles can be applied to produce integrated coil design.

For example, consider the case of a screened coil system, where a target field B(r,z) is required in some interior region (r < a) and a second target field of B=O is required in the exterior region r > b. Two cylindrical surface currents are then necessary, at radii a and b, where b > a.

In this approach we generalise Equation 1 to${\text{0=[bI}}_{\text{m}}^{\text{'}} \left(\text{kb}\right) {\text{j}}_{\text{φ}}^{\text{l,m}} \left(\text{k}\right) {\text{+aI}}_{\text{m}}^{\text{'}} \left(\text{ka}\right) {\text{j}}_{\text{φ}}^{\text{2,m}} \left(\text{k}\right) {\text{]K}}_{\text{m}} \left(\text{kr}\right)$${\text{kB}}_{\text{z}}^{\text{m}} \left(\text{k,r}\right) {\text{= -µ}}_{\text{o}} {\text{[bK}}_{\text{m}}^{\text{'}} \left(\text{kb}\right) {\text{j}}_{\text{φ}}^{\text{l,m}} \left(\text{k}\right) {\text{+aK}}_{\text{m}}^{\text{'}} \left(\text{ka}\right) {\text{j}}_{\text{φ}}^{\text{2,m}} \left(\text{k}\right) {\text{]I}}_{\text{m}} \left(\text{kr}\right)$ where B_{φ}(k,r) is the Fourier transform of the desired target field defined on a prescribed target surface j$\frac{\text{1}}{\text{φ}}$(z) is the surface current density on a cylinder radius b, and j$\frac{\text{2}}{\text{φ}}$(z) is the surface current density on a cylinder of radius a. The Fourier transforms of the resulting current densities can be written explicitly as:-${\text{j}}_{\text{φ}}^{\text{1,m}} \left(\text{k}\right) \text{=} \frac{{\text{-B}}_{\text{z}}^{\text{m}} \left(\text{kr}\right)}{{\text{µ}}_{\text{o}} {\text{bk I}}_{\text{m}} \left(\text{kr}\right) {\text{[K}}_{\text{m}}^{\text{'}} \left(\text{kb}\right) \text{-} \frac{{\text{I}}_{\text{m}}^{\text{'}} \left(\text{kb}\right)}{{\text{I}}_{\text{m}}^{\text{'}} \left(\text{ka}\right)} {\text{·K}}_{\text{m}}^{\text{'}} \left(\text{ka}\right) \text{]}}$${\text{j}}_{\text{φ}}^{\text{2,m}} \left(\text{k}\right) \text{=} \frac{\text{-b}}{\text{a}} \frac{{\text{I}}_{\text{m}}^{\text{'}} \left(\text{kb}\right)}{{\text{I}}_{\text{m}}^{\text{'}} \left(\text{ka}\right)} {\text{· j}}_{\text{φ}}^{\text{l,m}} \left(\text{K}\right)$

For a uniform field B along the z-axis, a possible target function is${\text{B}}_{\text{z}} \text{(z,r,φ) = f(z)g(r,φ) = B{1 + (} \frac{\text{z}}{\text{p}} {\text{)}}^{\text{ℓ}} \text{[1 - exp - (} \frac{\text{z}}{\text{q}} {\text{)}}^{\text{m}} {\text{]}}}^{\text{-1}}$ where p and q are assignable constants, 1 m assignable integers and g(r,φ) = B is in this case independent of r and φ. By choosing 1= 3 we ensure that the far field varies as 1/z. Other types of coil may require specific r and φ dependence as reflected in g(r,o) together with a different value for 1*.* For a short solenoid, the axial variation of field would go as z^{1+m}. The constant p is approximately equal to coil radius and q the coil half-length. The procedure is therefore to evaluate f(k) from Equation (30). Equations (27a and b) are then solved for j$\frac{\text{1}}{\text{φ}}$(k) and j$\frac{\text{2}}{\text{φ}}$(k). These current densities are then inversely transformed to yield the actual current density distributions. For a uniform field gradient alonq the z-axis, the target function is simply zf(z) with appropriate adjustments in 1 and m.

Although the Bessel functions are used as single hoop response functions, Equation (27) may be generalised to any coordinate system and arbitrary coil and screen geometry. In this case we may write Equation (30) generally as${\text{0 = B}}_{\text{o,1}}^{\text{e}} \text{(} {\text{k}}_{̲} {\text{)j}}_{\text{1}} \text{(} {\text{k}}_{̲} {\text{) + B}}_{\text{o,2}}^{\text{e}} \text{(} {\text{k}}_{̲} {\text{)j}}_{\text{2}} \text{(} {\text{k}}_{̲} \text{)}$${\text{B}}^{\text{i}} \text{(} {\text{k}}_{̲} {\text{)=- B}}_{\text{o,1}}^{\text{i}} \text{(} {\text{k}}_{̲} {\text{)j}}_{\text{1}} \text{(} {\text{k}}_{̲} {\text{), - B}}_{\text{o,2}}^{\text{i}} \text{(} {\text{k}}_{̲} {\text{)j}}_{\text{2}} \text{(} {\text{k}}_{̲} \text{)}$ where B$\frac{\text{α}}{\text{o,n}}$(k) are the k-space unit current response functions for a line or loop element calculated from the Biot-Savart Law and evaluated along a path in real space externally (e) or internally (i) with respect to the loop element.

Further screens may be added. For n active screens a generalised n x n matrix equation is obtained:-${\text{B}}_{̲} \text{(} {\text{k}}_{̲} \text{) = -} {\text{B}}_{̲} {\text{}}_{\text{o}} \text{(} {\text{k}}_{̲} \text{)} {\text{j}}_{̲} \text{(} {\text{k}}_{̲} \text{)}$ where Bₒ(k) is the generalised transfer matrix for the set of screens. B(k) is the specified field or target response vector and j(k) the current density vector. For finite screen and/or coil currents, we also require detBₒ(k)≠O. So far we have considered specification of the target response vector along one coordinate axis. For specification along two axes B(k) or j(k) and Bₒ(k) become 2nd and 3rd rank tensors respectively.

The above description is mainly concerned with screening fields, so that beyond a given radius, the field vanishes. However from the analysis presented the reverse case may also have application. For example, generation of magnetic fields of known spatial dependence external to the coil system structure could be useful in surface coil design and also in the design of magnets, gradient coils and RF coils in oil borehole NMR spectrometers.

## Claims

1. A method of producing a coil, which is wound on at least one surface and is designed to produce a specified non-zero magnetic field when energised, but is not designed to screen the field of another coil, the said non-zero magnetic field being specified on a target surface or target surfaces, which are of different size from the at least one first-mentioned surface, said method including the steps of
a) calculating the surface current distribution in reciprocal space and inverting it to r-space to produce the exact continuous current density required on the at least one first-mentioned surface to generate the specified non-zero magnetic field everywhere on the target surface or surfaces, this current density being calculated using either the following equation for a cylindrical coordinate system and coil geometry${\text{F}}_{\text{φ}}^{\text{m}} \left(\text{k}\right) \text{=-} \frac{\text{1}}{{\text{µ}}_{\text{o}} \text{a}} \frac{{\text{B}}_{\text{z}} \left(\text{m,k}\right)}{{\text{k K}}_{\text{m}}^{\text{'}} \left(\text{ka}\right) {\text{I}}_{\text{m}} \left(\text{kc}\right)}$ wherein:
a is the radius of a cylindrical first-mentioned surface,
c is the radius of a target cylindrical surface,
B_{z} is the magnetic field in the axial direction,
F is the surface current density which has components F_{φ} and F_{z} in the azimuthal and axial directions respectively,
k is the axial variable reciprocal to the axial distance variable z in the cylindrical coordinate system
m is the angular harmonic reciprocal to the azimuthal angle variable φ in the cylindrical coordinate system,
Iₘ and Kₘ are the modified Bessel functions of the first and second kinds respectively,
or an equivalent equation generalised to any coordinate system and arbitrary coil geometry,
b) calculating conductor positions from the stream function of the current density on the at least one first-mentioned surface, and
c) winding the conductors onto the at least one first-mentioned surface in the calculated positions to provide, when energised, the specified non-zero magnetic field.

2. The method as claimed in Claim 1 in which the first-mentioned surface or surfaces are cylinders and the target surface or surfaces are also cylinders.

3. The method as claimed in Claim 2 in which the coil conductors are to be mounted on one cylinder which is of larger diameter than the diameter of the target cylinder, the coil therefore being designed to produce a known field within the target cylinder.

4. The method as claimed in Claim 2 in which the target cylinder is of larger diameter than the cylinder on which the coil conductors are to be mounted.

5. The method as claimed in Claim 2 in which the coil is wound on two cylindrical surfaces and the coil design is obtained from calculations carried out on first and second target cylinders, the first being of smaller diameter and the second of larger diameter than either of said two cylindrical surfaces.

6. The method as claimed in Claim 5 in which a plurality of coaxial cylindrical or semicylindrical coils are designed to produce various fields specified on target cylinders in the intervening spaces and within the central cylinder.

## Patentansprüche

1. Ein Verfahren zum Herstellen einer Spule, die um mindestens eine Oberfläche gewickelt ist und konstruiert ist, um ein bestimmtes, von Null verschiedenes Magnetfeld zu erzeugen, wenn sie erregt wird, aber nicht konstruiert ist, um das Feld einer anderen Spule abzuschirmen, wobei das von Null verschiedene Magnetfeld auf einer Zieloberfläche oder Zieloberflächen bestimmt wird, die eine von der mindestens einen erstgenannten Oberfläche verschiedene Größe haben, wobei das Verfahren die Schritt enthält
a) Berechnen der Oberflächenstromverteilung in einem reziproken Raum und Invertieren dieser in einen r-Raum, um die exakte stetige Stromdichte zu erzeugen, die auf der mindestens einen erstgenannten Oberfläche erforderlich ist, um das bestimmte, von Null verschiedene Magnetfeld überall auf der Zieloberfläche oder den Oberflächen zu erzeugen, wobei diese Stromdichte unter Verwendung von entweder der folgenden Gleichung für ein Zylinderkoordinatensystem und eine Spulengeometrie${\text{F}}_{\text{φ}}^{\text{m}} \left(\text{k}\right) \text{=-} \frac{\text{1}}{{\text{µ}}_{\text{o}} \text{a}} \frac{{\text{B}}_{\text{z}} \left(\text{m,k}\right)}{{\text{k K}}_{\text{m}}^{\text{'}} \left(\text{ka}\right) {\text{I}}_{\text{m}} \left(\text{kc}\right)}$ worin:
a der Radius einer zylindrischen erstgenannten Oberfläche ist,
c der Radius einer zylindrischen Zieloberfläche ist,
B_{z} das Magnetfeld in der Achsenrichtung ist,
F die Oberflächenstromdichte ist, die Komponenten F_{φ} und F_{z} in den Azimut- bzw. Achsenrichtungen hat,
k die zu der Achsenabstandsvariable z in dem
Zylinderkoordinatensystem reziproke Achsenvariable ist,
m die zu der Azimutwinkelvariable φ in dem Zylinderkoordinatensystem reziproke Winkelharmonische ist,
Iₘ und Kₘ die modifizierten Besselfunktionen der ersten bzw. zweiten Art sind,
oder einer entsprechenden, für ein beliebiges Koordinatensystem und eine beliebige Spulengeometrie verallgemeinerten Gleichung berechnet wird,
b) Berechnen von Leiterstellen aus der Stromfunktion der Stromdichte auf der mindestens einen erstgenannten Oberfläche, und
c) Wickeln der Leiter auf die mindestens eine erstgenannte Oberfläche an den berechneten Stellen, um bei Erregung das bestimmte, von Null verschiedene Magnetfeld zu liefern.

2. Das Verfahren nach Anspruch 1, worin die erstgenannte Oberfläche oder Oberflächen Zylinder sind und die Zieloberfläche oder Oberflächen ebenfalls Zylinder sind.

3. Das Verfahren nach Anspruch 2, worin die Spulendrähte auf einem Zylinder zu befestigen sind, der einen größeren Durchmesser als der Durchmesser des Zielzylinders hat, wobei die Spule daher konstruiert ist, um ein bekanntes Feld in dem Zielzylinder zu liefern.

4. Das Verfahren nach Anspruch 2, worin der Zielzylinder einen größeren Durchmesser als der Zylinder hat, auf dem die Spulendrähte zu befestigen sind.

5. Das Verfahren nach Anspruch 2, worin die Spule auf zwei zylindrische Oberflächen gewickelt wird und die Spulenkonstruktion aus Berechnungen erhalten wird, die an ersten und zweiten Zielzylindern ausgeführt werden, wobei der erste einen kleineren Durchmesser und der zweite einen größeren Durchmesser als jede der beiden zylindrischen Oberflächen hat.

6. Das Verfahren nach Anspruch 5, worin mehrere koaxiale zylindrische oder halbzylindrische Spulen konstruiert sind, um verschiedene Felder zu liefern, die auf Zielzylindern in den Zwischenräumen und in dem zentralen Zylinder bestimmt sind.

## Revendications

1. Procédé pour produire un enroulement, qui est enroulé sur au moins une surface et qui est conçu pour produire un champ magnétique différent de zéro spécifié lorsqu'il est excité, mais qui n'est pas conçu pour constituer un écran vis-à-vis du champ d'un autre enroulement, ledit champ magnétique différent de zéro étant spécifié sur une surface-cible ou sur des surfaces-cibles, qui sont de taille différente de celle de la ou des surfaces mentionnées en premier, ledit procédé comprenant les étapes suivantes :
a) le calcul de la distribution de courant de surface dans l'espace réciproque et l'inversion de celle-ci dans un espace r pour produire la densité de courant continu exacte requise sur la ou les surfaces mentionnées en premier afin de générer le champ magnétique différent de zéro spécifié partout sur la surface-cible ou sur les surfaces-cibles, cette densité de courant étant calculée en utilisant soit l'équation suivante pour un système de coordonnées cylindriques et une géométrie d'enroulement :${\text{F}}_{\text{φ}} {}^{\text{m}} \left(\text{K}\right) \text{= -} \frac{\text{1}}{{\text{µ}}_{\text{o}} \text{a}} \frac{{\text{B}}_{\text{z}} \left(\text{m,k}\right)}{{\text{k K}}^{\text{'}} {}_{\text{m}} \left(\text{ka}\right) {\text{I}}_{\text{m}} \left(\text{kc}\right)}$ dans laquelle :
a est le rayon d'une surface cylindrique mentionnée en premier,
c est le rayon d'une surface cylindrique cible,
B_{z} est le champ magnétique dans la direction axiale,
F est la densité de courant de surface qui comporte des composantes F_{φ} et F_{z} dans les directions azimutale et axiale, respectivement,
k est la variable axiale réciproque à la variable de distance axiale z dans le système de coordonnées cylindriques,
m est l'harmonique angulaire réciproque à la variable d'angle azimutal φ dans le système de coordonnées cylindriques,
Iₘ et Kₘ sont les fonctions de Bessel modifiées des premier et deuxième types, respectivement,
soit une équation équivalente généralisée à un système de coordonnées quelconque et à une géométrie d'enroulement arbitraire,
b) le calcul des positions de conducteurs à partir de la fonction d'écoulement de la densité de courant sur la ou les surfaces mentionnées en premier, et
c) l'enroulement des conducteurs sur la ou les surfaces mentionnées en premier, une dans les positions calculées afin de réaliser, lorsqu'ils sont excités, le champ magnétique différent de zéro spécifié.

2. Procédé selon la revendication 1, dans lequel la ou les surfaces mentionnées en premier sont des cylindres, et la surface-cible ou les surfaces-cibles sont également des cylindres.

3. Procédé selon la revendication 2, dans lequel les fils d'enroulement doivent être montés sur un cylindre qui a un diamètre supérieur au diamètre du cylindre-cible, l'enroulement étant par conséquent conçu pour produire un champ connu à l'intérieur du cylindre-cible.

4. Procédé selon la revendication 2, dans lequel le cylindre-cible a un diamètre supérieur à celui du cylindre sur lequel les fils d'enroulement doivent être montés.

5. Procédé selon la revendication 2, dans lequel l'enroulement est enroulé sur deux surfaces cylindriques et la conception d'enroulement est obtenue à partir de calculs effectués sur de premier et deuxième cylindres-cibles, le premier ayant un diamètre inférieur et le deuxième ayant un diamètre supérieur à ceux desdites deux surfaces cylindriques.

6. Procédé selon la revendication 5, dans lequel une pluralité d'enroulements semi-cylindriques ou cylindriques coaxiaux sont conçus pour produire différents champs spécifiés sur des cylindres-cibles dans les espaces de séparation et à l'intérieur du cylindre central.
